# EUROPÄISCHE PATENTSCHRIFT

(11) **EP 2 807 114 B1**
(45) Veröffentlichungstag und Bekanntmachung des Hinweises auf die Patenterteilung: **16.03.2016**
(21) Anmeldenummer: 12706316.2
(22) Anmeldetag: 25.01.2012
(51) Int. Cl.: C01B 21/072, C30B 25/00, C30B 29/62, C30B 29/40, C30B 29/60, B82Y 30/00

(54) **HERSTELLUNGSVERFAHREN VON NANOKRISTALLEN AUS PIEZOELEKTRISCHEM ALUMINIUMNITRID FÜR SORPTIONSFILTER**
METHOD FOR PRODUCING NANOCRYSTALS FROM PIEZOELECTRIC ALUMINIUM NITRIDE FOR SORPTION FILTERS
PROCÉDÉ DE FABRICATION DE NANOCRISTAUX EN NITRURE D'ALUMINIUM PIÉZOÉLECTRIQUE POUR FILTRES À SORPTION

(43) Veröffentlichungstag der Anmeldung: 03.12.2014
(73) Patentinhaber: Potemkin, Alexander, 22885 Barsbüttel (DE)
(72) Erfinder: POTEMKIN , Alexander, 22885 Barsbüttel (DE)
(74) Vertreter: Säger, Manfred
(86) Internationale Anmeldenummer: PCT/IB2012/000110
(87) Internationale Veröffentlichungsnummer: WO 2013/110964

(56) Entgegenhaltungen:
- US-A- 3 653 830
- CONGKANG XU ET AL: "Formation and photoluminescence properties of AlN nanowires", PHYSICA STATUS SOLIDI (A), Bd. 198, Nr. 2, 1. August 2003 (2003-08-01), Seiten 329-335, XP055045647, ISSN: 0031-8965, DOI: 10.1002/pssa.200306612
- AITA C R ET AL: "Nanocrystalline aluminum nitride: Growth by sputter deposition, optical absorption, and corrosion protection behavior", NANOSTRUCTURED MATERIALS, ELSEVIER, NEW YORK, NY, US, Bd. 1, Nr. 4, 1. Juli 1992 (1992-07-01), Seiten 269-282, XP024174617, ISSN: 0965-9773, DOI: 10.1016/0965-9773(92)90034-U [gefunden am 1992-07-01] in der Anmeldung erwähnt

## Beschreibung

Die Geschichte der Synthese von Nanodrähten schwer schmelzbarer Verbindungen reicht bis in die 70er Jahre des letzten Jahrhunderts zurück, als bekannt wurde, dass mit abnehmendem Querschnitt von Whiskern ihre Festigkeitsgrenze theoretische Werte erreicht.
Offensichtlich wurde die praktische Verwendbarkeit der Whisker bei der Herstellung von Verbundmaterialien, hochfesten und hochmodularen Materialien auf der Basis von Polymeren, Metallen, Keramiken und Graphit für neuartige Materialien. Es kam zur fabrikmässigen Produktion von Whiskern aus Siliziumkarbid und -nitrid, Aluminiumoxid und -nitrid usw.; sie wurden nicht nur wegen ihrer Festigkeit studiert, sondern auch unter funktionalen Gesichtspunkten - Wärmeleitfähigkeit, Piezoelektrizität, Elektrokondensation usw. Whisker wurden aus einer festen Charge des Grundelements gezüchtet, der man solche Verbindungen des betreffenden Elements hinzufügte, die bei Erwärmung und fast atmosphärischem Druck (1,2 atm) in reaktivem oder inertem Milieu leicht in die gasförmige Phase übergehen. Die Analyse der erzielten Abmessungen zeigte, dass die Dispersität der Whisker grundsätzlich von der Grösse des Tropfens des Grundelements auf der Oberfläche des Keims abhängt, dessen Wachstum durch den VLS-Mechanismus (VLS von englisch vapor liquid solid, dt. Dampf-Flüssigkeits-Feststoff-Methode) stimuliert wird, und praktisch nicht zu steuern ist. Die Abmessungen der meisten Whisker lagen im Bereich von 1 - 500 µm Durchmesser und der Löwenanteil bei 100 - 300 µm. Versuche, bei normalem Luftdruck Nanowhisker herzustellen, misslangen. Das grösste Interesse unter funktionalen Gesichtspunkten zogen solche piezoelektrischen Whisker aus Aluminiumnitrid mit kubischer Modifikation (Patent 2106 298 RF SO 1 V 21/072) auf sich, die aus der gasförmigen Phase bei 1100 - 1300 °C in einer Stickstoff- oder Ammoniakatmosphäre aus einer Al+AlF₃-Charge gezüchtet wurden (Patent 2136 587 RF SO 1 V 21/072 BI 1999 Nr. 25). Aber man schaffte es nicht, den Durchmesser der so gewonnenen Whisker auf unter 0,15 µm zu drücken, und dabei machte ihr Anteil an der Gesamtproduktmasse gerade einmal 1,5 - 2 Vol.% aus und ihre Abtrennung verteuerte die Whisker um das 1000-fache. Der Versuch, AlN-Nanowhisker aus der Gasphase durch Absetzung von Aluminiumhydrid auf einer heissen Unterlage in einer Stickstoffatmosphäre zu züchten (Nanostruct. Mater. 1992, Bd. 4, S. 269) erhöhte die Ausbeute an Whiskern nur unwesentlich (weniger als 0,1 - 0,2 Vol.%) bei einem Mindestdurchmesser von 1000 Å.

Erste Erfahrungen mit fabrikmässig (Chemiefabrik Redkino, Gebiet Moskau) hergestellten Whiskern aus Aluminiumnitrid stammen aus dem Jahr 1975. Sie wurden als Wärmeisolierung des heissen Teils einer unter einem Stickstoffdruck von 200 MPa und einer Temperatur von 2000 °C arbeitenden Druckkammer genutzt. Wir entdeckten, dass die Whisker, die am nächsten an der heissen Zone lagen, sich durch Umkristallisation aus 250 µm grossen in kleine von 0,1 bis 1 µm Grösse verwandelten und das zu 98 %. Die Erhöhung des Stickstoffdrucks auf 500 MPa bei gleichbleibender Temperatur senkte den Durchmesser der Kristalle nur minimal auf 0,1 - 0,5 µm.

In einem weiteren Verfahren werden Whisker aus hexagonalem Aluminiumnitrid hergestellt, indem Aluminiumpulver in einem Ammoniak-Strom auf 1050°C geheizt wird. Die Whisker haben Durchmesser von 5-40 nm und Längen im Bereich von mehreren Zehnern Mikrometern (phys. stat. sol. (a) 2003, Bd. 198, Nr. 2, S. 329). Beim nächsten Experiment wurde versucht, die Whisker bei einem Druck des Stickstoffs von 1000 MPa und einer Temperatur von 2300 K aus einer aus Aluminiumpulver mit einer Beimengung von Aluminiumhydrid bestehenden Charge zu züchten. Die jetzt gewonnen Kristalle hatten zu 99 % einen Durchmesser von 10 - 70 Å. Nach der Tränkung mit einem Gasgemisch aus He + 30 % O₂ zeigte sich eine hohe Sorptionsfähigkeit gegenüber Luft mit einem Anteil radioaktiver Isotope von Xenon, Zäsium u. a.
Hier verschafft die Erfindung Abhilfe. Sie ist in den Gegenständen der Ansprüche gekennzeichnet.

### BEISPIELE FÜR DIE UMSETZUNG DER ERFINDUNG

1. Die Charge zur Züchtung der Nanodrähte wurde in einer Vibrationsmühle aus Aluminiumpulver der Sorte SAP mit einer Beimengung von AlH₃-Lösung in Tetrahydrofuran (5 g/100 g) in der Grössenordnung von 2 - 10 Vol.% innerhalb von 30 - 45 Minuten hergestellt.
2. Die fertige Charge wurde in Graphitbehälter aus feinkörnigem dichten Graphit (MPG) mit einem Querschnitt von 50 x 5 mm und einer Wandstärke von 1,5 mm in einer max. 2 mm dicken Schicht eingebracht.
3. Die Behälter mit der Charge wurden auf einem Gestell auf dem Objekttisch des Druckkammerofens abgestellt, auf 10⁻² Torr vakuumiert, Helium mit einer 30-Vol.%igen Beimengung von Sauerstoff bis zu einem Druck von 100 atm eingelassen, danach wurde wieder vakuumiert und das Ganze drei Mal wiederholt, danach wurde der Druck des Stickstoffs (mit einer 3 - 5-Vol.%igen Beimengung von Ammoniak) auf 200 - 2000 MPa erhöht und der Erhitzer eingeschaltet, mit einer Geschwindigkeit von max. 10 °C/min die Temperatur auf 2000 °C erhöht und während 3 - 5 Stunden gehalten.
4. Nach Abschluss der Exposition werden Druck und Temperatur auf Normalwerte abgesenkt, die Druckkammer mit einer schmierungslosen elektrophysikalischen Pumpe auf 10⁻⁶ Torr vakuumiert, danach mit einem Gemisch aus He + 30 Vol.% O₂ bis auf einen Druck von 200 - 2000 MPa gefüllt und 30 Minuten in diesem Zustand belassen, danach wird der Druck auf Luftdruck abgesenkt und die Behälter mit den Nanodrähten aus der Druckkammer gezogen.
5. Die herausgenommenen Nanodrähte haben das Aussehen von Watte und werden zwischen Schichten aus Petrjanov-Gewebe gepackt und in ein elektrisches Feld von 100 - 1000 V gelegt.
6. Die Anbringung der Nanodrähte auf dem Filter wird aus den oberen Behältern vorgenommen, die an der den Atemorganen zugewandten Innenseite des Filters angebracht werden.
7. Die Analyse der Nanodrähte aus den oberen und unteren Behältern hat einen starken Unterschied in der Gewichtszunahme der Sorptionskomponente (He + 30 Vol.% O₂) um durchschnittlich 10 - 15 % erwiesen.
8. Die Bestimmung der spezifischen Oberfläche der Nanodrähte hat erbracht, dass sie in Abhängigkeit von der Unterbringungshöhe der Behälter zwischen 15000 - 35000 m/g schwankt.
9. Der Querschnitt der gezüchteten Nanodrähte ist ebenfalls von der Unterbringungshöhe des Behältnisses abhängig und liegt nach den elektronenmikroskopischen Angaben bei 99 % des Chargenvolumens 10 - 20 Å.
10. Die Bestimmung der kapazitiven Ladung an der Innenseite der Filter zeigte eine Verteilung der Messwerte zwischen 0,8 - 0,95 Q, die offensichtlich durch die unterschiedliche spezifische Oberfläche der Nanodrähte und dementsprechend der sorbierten Menge He + O₂ verursacht ist.
11. Die mit dem Lauegramm eines stark fokussierten Elektronenbündels des Mikroskops mit einer Spannung von 1 Millionen Volt berechnete Kristalldichte betrug 3,2 - 3,25 g/cm³, das bedeutet einen kubischen Gittertyp.

## Patentansprüche

1. Herstellungsverfahren für Nanodrähte aus piezoelektrischem Aluminiumnitrid, **dadurch gekennzeichnet, dass** zur Gewinnung von Nanodrähten aus kubischem AIN mit einem Durchmesser von 10 - 20 Å und einer Länge von 1000 - 1500 Å diese aus einer Charge von Al + 2-10 Vol.% AlH₃ bei einer Temperatur von 1500 - 2300 °K in einem gasförmigen Milieu von N₂ + (3-5 Vol% NH₃) unter einem Druck von 200 - 2000 MPa gezogen werden.

2. Verfahren nach Anspruch 1, **dadurch gekennzeichnet, dass** als Chargengaundlage pulverförmiges Aluminium der Sorte SAP mit einer Beimengung von AlH₃-Lösung in Tetrahydrofuran (5 g/100 g) in der Grössenordnung von 2 - 10 Vol.% benutzt wird, welches in Graphitbehältezn mit einem Querschnitt von 50 x 10 mm untergebracht wird.

3. Verfahren nach Anspruch 1 oder 2, **dadurch gekennzeichnet, dass** die bestückten Graphitbehälter in eine Druckkammer (Gasostat) gegeben werden, mehrmals mit Helium mit einer Beimengung O₂ gespült werden, danach der Druck in der Druckkammer auf 200 - 2000 MPa eines Gemisches aus N₂ + (3-5 Vol.% NH₃) gesteigert wird, die Temperatur in der Druckkammer auf 2000 °K mit einer Geschwindigkeit von höchstens 10 °C/min erhöht und 3 - 5 Stunden gehalten wird.

4. Verfahren nach Anspruch 1,2 oder 3, dadurch gekenntzeichnet, dass nach dieser Exposition, der Abkühlung und Druckminderung eine Vakuumierung auf 10⁻⁶ Torr durchgeführt wird, danach die Druckkammer mit einem Gemisch aus He + 30 Vol.% O₂ bis zum Erreichen eines Drucks von 200 - 2000 MPa befüllt wird, der 30 Minuten gehalten wird, anschliessend der Druck bis auf den Luftdruck gesenkt wird, die Druckkammer geöffnet und die AlN-Kristalle herausgezogen werden,

## Claims

1. A method for producing nanowires from piezoelectric aluminium nitride, **characterized in that** in order to obtain nanowires from cubic AlN having a diameter of 10-20 Å and a length of 1000-1500 Å, said nanowires are obtained from a batch of Al+2-10 % by volume AlH₃ at a temperature of 1500-2300 °K in a gaseous environment of N₂+(3-5% by volume NH₃) at a pressure of 200-2000 MPa.

2. The method according to claim 1, **characterized in that** SAP powder aluminium with an addition of AlH₃ solution in tetrahydrofurane (5 g/100 g) in the order of between 2-10 % by volume is used as the charge basis, said powder aluminium being stored in graphite containers having a cross section of 50 x 10 mm.

3. The method according to claim 1 or 2, **characterized in that** the charged graphite container is placed into a pressure chamber (gasostat), rinsed a plurality of times with helium with O₂ added, the pressure in the pressure chamber of a mixture of N₂+(3-5 % by volume NH₃) is later increased to 200-2000 MPa, the temperature in the pressure chamber is increased to 2000 °K at a rate of no more than 10 °C/min and maintained for 3-5 hours.

4. The method according to claim 1, 2 or 3, **characterized in that** after this exposure, cooling and pressure reduction, a vacuum of 10⁻⁶ Torr is applied, after which the pressure chamber is filled with a mixture of He + 30 % by volume O₂ until a pressure of 200-2000 MPa is reached which is held for 30 minutes, after which the pressure is reduced to atmospheric pressure, the pressure chamber is opened and the AlN crystals are removed.

## Revendications

1. Procédé de fabrication pour nanofils de nitrure d'aluminium piézoélectrique **caractérisé en ce que** pour obtenir des nanofils d'AlN cubique avec un diamètre de 10 - 20 Å et d'une longueur de 1000 - 1500 Å, ceux-ci sont étirés à partir d'une charge de Al+2-10 % en volume de AlH₃ à une température de 1500 - 2300 °K dans un milieu gazeux de N₂ + (3-5 % en volume de NH₃) sous une pression de 200 - 2000 MPa.

2. Procédé selon la revendication 1 **caractérisé en ce que** de l'aluminium pulvérulent du type SAP avec une addition de solution AlH₃ dans du tétrahydrofuranne (5g/100 g) dans l'ordre de grandeur de 2 - 10 % en volume est utilisé comme base de charge, lequel est placé dans des conteneurs de graphite avec une section de 50 x 10 mm.

3. Procédé selon la revendication 1 ou 2 **caractérisé en ce que** les conteneurs de graphite équipés sont mis dans une chambre sous pression (gazostat), sont rincés plusieurs fois à l'hélium avec une addition de 0₂, puis la pression dans la chambre sous pression est montée à 200 - 2000 MPa d'un mélange de N₂ + (3-5 % en volume de NH₃), la température dans la chambre sous pression est élevée à 2000 °K à une vitesse de 10°C/min maximum et maintenue 3 - 5 heures.

4. Procédé selon la revendication 1, 2 ou 3 **caractérisé en ce qu'**une mise sous vide à 10⁻⁶ Torr est effectuée après cette exposition, le refroidissement et la réduction de pression, ensuite la chambre sous pression est remplie d'un mélange de He + 30 % en volume de O₂ jusqu'à l'obtention d'une pression de 200 - 2000 MPa, qui est maintenue 30 minutes, puis la pression est abaissée jusqu'à la pression atmosphérique, la chambre sous pression est ouverte et les cristaux d'AlN sont extraits.
